# EUROPEAN PATENT APPLICATION

(11) **EP 1 886 814 A2**
(43) Date of publication of application: **13.02.2008**
(21) Application number: 07013383.0
(22) Date of filing: 09.07.2007
(51) Int. Cl.: B41F 31/00

(54) **Information recording medium supply apparatus**

(30) Priority: 09.08.2006 JP 2006216668
(71) Applicant: Komori Corporation, Sumida-ku Tokyo (JP)
(72) Inventor: Kusaka, Akehiro, Noda-shi, Chiba (JP)
(74) Representative: UEXKÜLL & STOLBERG

(57) **Abstract**

An information recording medium supply apparatus comprises: a gravure plate cylinder (35) supported having recessed image areas (35b) formed in the circumferential surface thereof; an ink roller (36) for supplying ink from an ink reservoir (37) to the circumferential surface of the gravure plate cylinder (35) ; a doctor (38) for removing surplus ink adhering to non-image areas (35a) of the gravure plate cylinder (35) ; an impression cylinder (34) supported rotatably and adapted to transfer the ink in the image areas (35b) to a sheet (S) being transported in cooperation with the gravure plate cylinder (35) ; and an IC chip supply device (50) for supplying an IC chip to the ink in the image area (35b) on a side downstream of the point of removal of the ink by the doctor (38) in the rotating direction of the gravure plate cylinder (35), and on a side upstream of the point of contact with the impression cylinder (34) in the rotating direction of the gravure plate cylinder (35).

## Description

### Technical Field

This invention relates to an information recording medium supply apparatus capable of embedding, in a sheet being transported, an information recording medium, such as an IC chip, where information on the sheet is recorded.

### Background Art

In recent years, attention has been attracted to materials utilizing an information recording medium, such as an IC (integrated circuit) chip or an IC tag, as a tool for discriminating between a fake thing and a real thing. The IC chip has recording memories, central processing units (CPU),transistors,resistors,and capacitors,on a substrate to perform functions, such as information recording, and is packaged in a size as small as a sesame seed. The IC tag has an antenna mounted on the IC chip, and enables communication with the outside to be performed in a noncontact manner.

The IC chip or the IC tag has been put to various uses, which are typified by uses such as commuting passes or admission tickets. Recently, IC chips or IC tags have been embeddedinsecurities,etc.to permit advanced determination of authenticity, thereby preventing forgery, or they have been embedded in articles or slips to ensure automatic or efficient logistics management. Their further downsizing has also been promoted to work out unprecedented applications. For example, their use in gift certificates makes it possible to grasp flows in distribution of products instantaneously, thereby realizing effective marketing. Many other applications in wide varieties of fields are expected of them.

The above-described uses, namely, IC chip- or IC tag-embedded base materials, are printing products printed on sheets in most cases. Such printing products are high-class prints using photographs, etc., and security printing products such as banknotes and securities. The method of printing these high-class printing products or security printing products is intaglio printing. An intaglio printing press for doing such intaglio printing is disclosed, for example, in Japanese Patent Publication No. 1989-37272.

Printing products have hitherto been produced by a process starting in a paper making step and involving a printing step. To embed an IC chip in a printing product, the IC chip has to be embedded somewhere in the process before or after the printing step. In other words, with the conventional method, it has been necessary to newly add a step for embedding an IC chip or an IC tag in a sheet, for example, paper, thus entailing a manufacturing cost. When the IC chip is embedded before the printing step, in particular, the occurrence of waste paper during printing also spoils the embedded IC chip, probably causing a decrease in productivity.

### Summary of the Invention

The present invention has been accomplished as a solution to the above-described problems. It is an object of the invention to provide an information recording medium supply apparatus capable of efficiently embedding in a sheet an information recording medium where information on the sheet is recorded.

A first aspect of the present invention is an information recording medium supply apparatus, comprising:
a cylinder supported rotatably, and having a recessed portion formed in a circumferential surface thereof;
liquid supply means for supplying a liquid to the circumferential surface of the cylinder;
surplus liquid removal means for removing a surplus of the liquid adhering to a portion other than the recessed portion;
an impression cylinder supported rotatably and adapted to transfer the liquid in the recessed portion to a sheet being transported in cooperation with the cylinder; and
medium supply means for supplying an information recording medium, where information is recorded, to the liquid in the recessed portion on a side downstream of a point of removal of the liquid by the surplus liquid removal means in a rotating direction of the cylinder, and on a side upstream of a point of contact with the impression cylinder in the rotating direction of the cylinder.

A second aspect of the present invention is the information recording medium supply apparatus according to the first aspect, characterized in that the medium supply means comprises: a transport path extending toward the cylinder; and oscillation means which oscillates the transport path to supply the information recording medium from the transport path to the liquid in the recessed portion.

A third aspect of the present invention is the information recording medium supply apparatus according to the second aspect, characterized in that the oscillation means comprises: a support member for supporting the transport path to be pivotable; a cam in contact with a lower surface of the transport path; and a cam drive motor for rotationally driving the cam.

A fourth aspect of the present invention is the information recording medium supply apparatus according to the first aspect, characterized in that the medium supply means comprises: a transport belt which travels to supply the information recording medium to the liquid in the recessed portion.

A fifth aspect of the present invention is the information recording medium supply apparatus according to the first aspect , characterized in that the medium supply means comprises: a hydraulic cylinder which actuates a piston rod to supply the information recording medium to the liquid in the recessed portion.

A sixth aspect of the present invention is the information recording medium supply apparatus according to the first aspect, characterized in that the medium supply means comprises: an adhesive belt for holding the information recording medium by an adhesive force; and adhesive belt moving means which moves the adhesive belt to supply the information recording medium to the liquid in the recessed portion.

A seventh aspect of the present invention is the information recording medium supply apparatus according to the first aspect, characterized in that the medium supply means comprises: a charged belt for holding the information recording medium by static electricity; and charged belt moving means which moves the charged belt to supply the information recording medium to the liquid in the recessed portion.

An eighth aspect of the present invention is the information recording medium supply apparatus according to the first aspect, characterized in that the information recording medium sticks to the liquid in the recessed portion because of viscosity of the liquid when contacting the liquid, and is rotated and transported, together with the liquid, in accordance with rotation of the cylinder.

A ninth aspect of the present invention is the information recording medium supply apparatus according to the eighth aspect, characterized in that the information recording medium slides on the circumferential surface of the cylinder other than the recessed portion.

A tenth aspect of the present invention is the information recording medium supply apparatus according to the first aspect, further comprising: push-out means for pushing the information recording medium out toward the liquid in the recessed portion when the recessed portion and the medium supply means oppose each other.

An eleventh aspect of the present invention is the information recording medium supply apparatus according to the first aspect, further comprising: push-in means for pushing the information recording medium, which has been supplied to the recessed portion, into the liquid in the recessed portion gradually in accordance with rotation of the cylinder.

A twelfth aspect of the present invention is the information recording medium supply apparatus according to the first aspect, characterized in that an intaglio printing unit is composed of the cylinder, the liquid supply means, the surplus liquid removal means, and the impression cylinder.

A thirteenth aspect of the present invention is the information recording medium supply apparatus according to the first aspect, characterized in that the information recording medium is transferred to the sheet, which is held on the impression cylinder, together with the liquid in the recessed portion.

A fourteenth aspect of the present invention is the information recording medium supply apparatus according to the thirteenth aspect, characterized in that the information recording medium is disposed within the liquid transferred to the sheet.

A fifteenth aspect of the present invention is the information recording medium supply apparatus according to the first aspect, characterized in that the information recording medium is an IC chip.

A sixteenth aspect of the present invention is the information recording medium supply apparatus according to the first aspect, characterized in that the medium supply means includes a transport path comprising a first guide extending toward the cylinder and disposed upstream in the rotating direction of the cylinder, and a second guide extending toward the cylinder and disposed downstream in the rotating direction of the cylinder, a leading end of the first guide has a small clearance with respect to the cylinder, and a leading end of the second guide has a clearance, which is of a length substantially equal to a length of the information recording medium, with respect to the cylinder.

A seventeenth aspect of the present invention is the information recording medium supply apparatus according to the first aspect, characterized in that the medium supply means includes a transport path extending toward the cylinder, and the transport path is inclined downwardly from an upstream side in a transport direction of the information recording medium toward a downstream side in the transport direction of the information recording medium.

An eighteenth aspect of the present invention is the information recording medium supply apparatus according to the fourth aspect, characterized in that the transport belt has a plurality of engagement portions for transporting the information recording medium toward the cylinder, and the information recording medium engages each of the engagement portions.

A nineteenth aspect of the present invention is the information recording medium supply apparatus according to the fourth aspect, further comprising: detection means for detecting a rotation phase of the recessed portion; and a drive motor for driving the transport belt, and wherein the drive motor is driven in accordance with the rotation phase of the recessed portion detected by the detection means.

A twentieth aspect of the present invention is the information recording medium supply apparatus according to the fifth aspect, further comprising: detection means for detecting a rotation phase of the recessed portion, and wherein the hydraulic cylinder is driven in accordance with the rotation phase of the recessed portion detected by the detection means.

A twenty-first aspect of the present invention is the information recording medium supply apparatus according to the third aspect, characterized in that the support member supports a proximal end side of the transport path, and the cam contacts a distal end side of the transport path.

A twenty-second aspect of the present invention is the information recording medium supply apparatus according to the eleventh aspect, characterized in that the push-in means is spaced from the cylinder by a clearance decreasing as the push-in means extends from an upstream side in the rotating direction of the cylinder toward a downstream side in the rotating direction of the cylinder.

A twenty-third aspect of the present invention is the information recording medium supply apparatus according to the twelfth aspect, further comprising: a delivery unit downstream of the intaglio printing unit in a transport direction of the sheet, and not including a printing unit between the intaglio printing unit and the delivery unit.

A twenty-fourth aspect of the present invention is the information recording medium supply apparatus according to the twelfth aspect, further comprising: a printing unit upstream of the intaglio printing unit in a transport direction of the sheet.

A twenty-fifth aspect of the present invention is the information recording medium supply apparatus according to the twenty-fourth aspect, further comprising: a reversing device, provided between the printing unit and the intaglio printing unit, for switching between double-sided printing and single-sided printing on the sheet.

A twenty-sixth aspect of the present invention is the information recording medium supply apparatus according to the twenty- fourth aspect, characterized in that the printing unit is a lithographic printing unit.

A twenty-seventh aspect of the present invention is the information recording medium supply apparatus according to the twenty-fourth aspect, characterized in that the printing unit is a relief printing unit.

According to the information recording medium supply apparatus concerned with the present invention, therefore, the information recording medium can be embedded in the sheet efficiently. Moreover, embedding of the information recording medium can be performed simultaneously with ink transfer to the sheet. Thus, there is no need to add anew a step for embedding the information recording medium, and a printing product provided with the information recording medium can be completed in one pass. Furthermore, the information recording medium is disposed within the liquid, thus making it difficult to determine whether the information recording medium is present or absent, and making it possible to produce a printing product having a high degree of forgery preventing function.

### Brief Description of the Drawings

The present invention will become more fully understood from the detailed description given hereinbelow and the accompanying drawings which are given by way of illustration only, and thus are not limitative of the present invention, and wherein:
Fig. 1A is a schematic view of a sheet-fed printing press equipped with an information recording medium supply apparatus according to the present invention, Fig. 1B is a view showing the action of a reversing unit during single-sided printing, and Fig. 1C is a view showing the action of the reversing unit during double-sided printing;
Fig. 2 is a schematic view of the information recording medium supply apparatus according to a first embodiment of the present invention;
Fig. 3 is a schematic view of the information recording medium supply apparatus according to a second embodiment of the present invention;
Fig. 4 is a schematic view of the information recording medium supply apparatus according to a third embodiment of the present invention;
Fig. 5 is a schematic view of the information recording medium supply apparatus according to a fourth embodiment of the present invention;
Fig. 6 is a schematic view of the information recording medium supply apparatus according to a fifth embodiment of the present invention;
Fig. 7 is a schematic view of another sheet-fed printing press equipped with the information recording medium supply apparatus according to the present invention; and
Fig. 8 is a schematic view of still another sheet-fed printing press equipped with the information recording medium supply apparatus according to the present invention.

### Detailed Description

The information recording medium supply apparatus according to the present invention will now be described in detail by embodiments with reference to the accompanying drawings. In each embodiment, members having the same structures and functions are assigned the same reference numerals and symbols, and their explanations will be omitted in subsequent embodiments.

### Embodiment 1

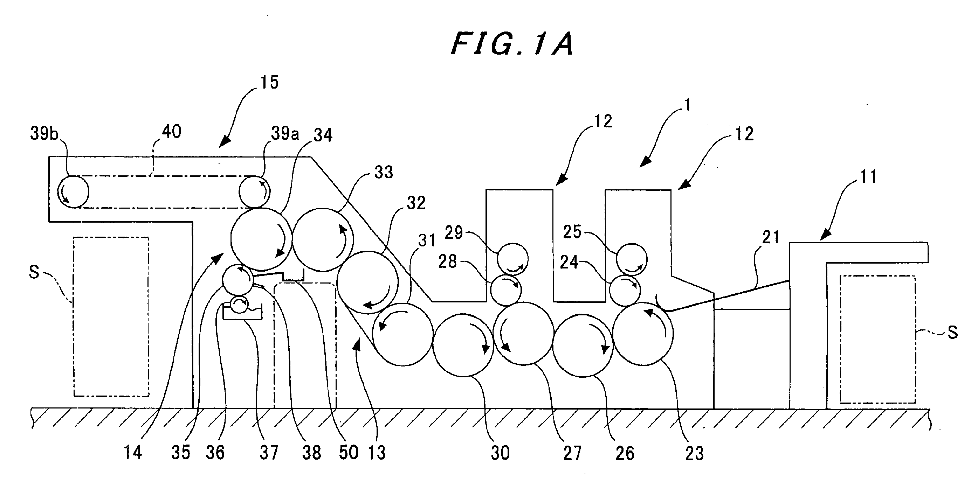

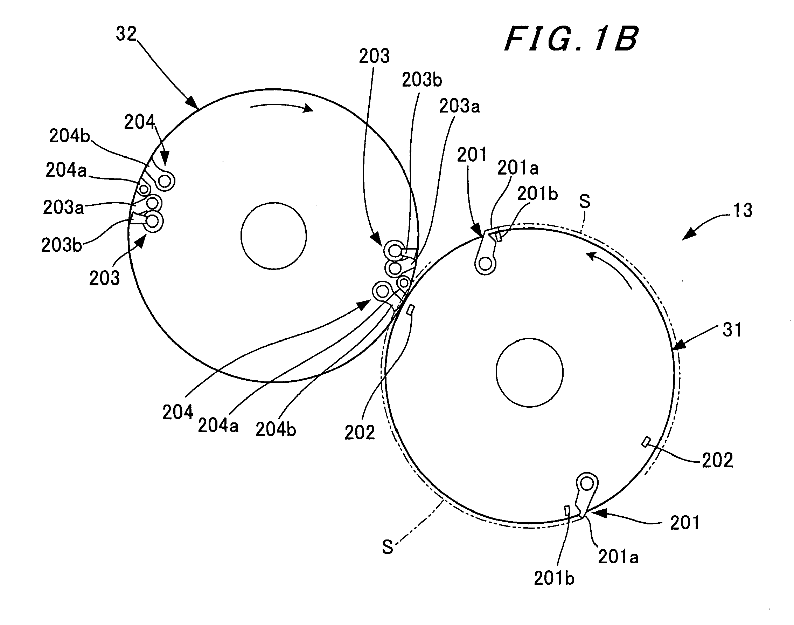

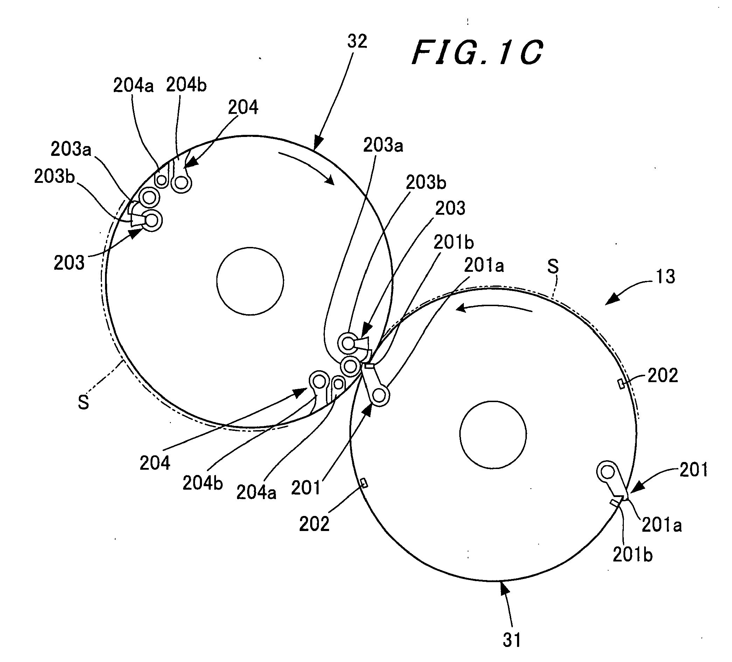

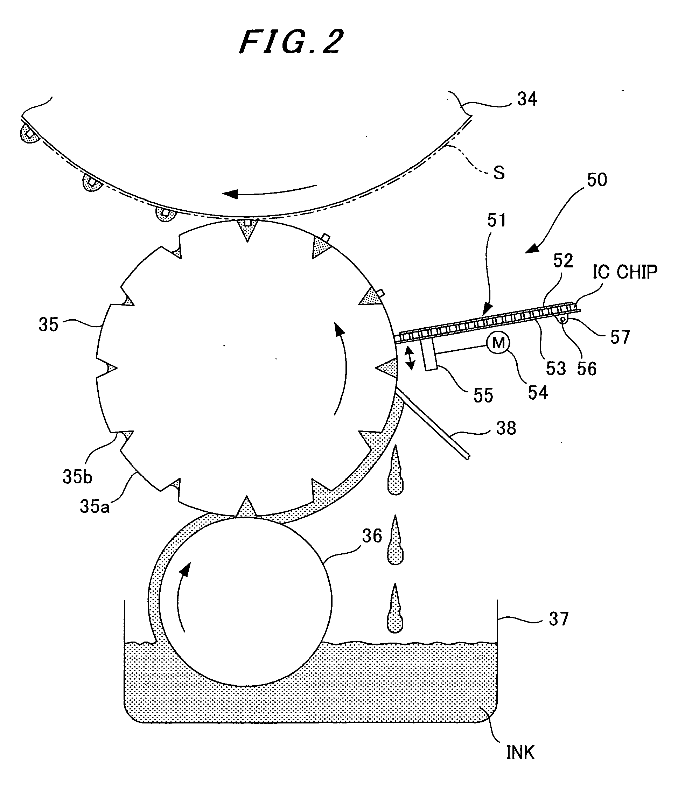

Fig. 1A is a schematic view of a sheet-fed printing press equipped with the information recording medium supply apparatus according to the present invention. Fig. 1B is a view showing the action of a reversing unit during single-sided printing. Fig. 1C is a view showing the action of the reversing unit during double-sided printing. Fig. 2 is a schematic view of the information recording medium supply apparatus according to a first embodiment of the present invention.

As shown in Fig. 1A, a sheet-fed rotary press 1 is equipped with a feeder 11, lithographic printing units 12, a reversing unit 13, a gravure printing unit (intaglio printing unit) 14, and a delivery unit 15. A sheet of paper(sheet) S passes through these devices sequentially, and thereby undergoes printing.

The feeder 11 is provided with a sheet feeding plate 21, and feeds the sheets S, one by one, from the sheet feeding plate 21 to the lithographic printing unit 12 via a swing arm shaft pregripper (not shown) provided at the leading end of the sheet feeding plate 21.

The lithographic printing unit 12 is provided with a first impression cylinder 23 which receives the sheet S fed from the sheet feedingplate 21. A first blanket cylinder 24 contacts the first impression cylinder 23 downstream of the sheet feeding plate 21 in the rotating direction of the first impression cylinder 23. A first lithographic plate cylinder 25 contacts the first blanket cylinder 24 upstream of the first impression cylinder 23 in the rotating direction of the first blanket cylinder 24. That is, the point of contact between the first impression cylinder 23 and the first blanket cylinder 24 serves as the first point of lithographic printing. A transfer cylinder 26 contacts the first impression cylinder 23 downstream of the first blanket cylinder 24 in the rotating direction of the first impression cylinder 23.

A second impression cylinder 27 contacts the transfer cylinder 26. Asecondblanket cylinder 28 contacts the second impression cylinder 27 downstream of the transfer cylinder 26 in the rotating directionof the second impression cylinder 27. A second lithographic plate cylinder 29 contacts the second blanket cylinder 28 upstream of the second impression cylinder 27 in the rotating direction of the second blanket cylinder 28. That is, the point of contact between the second impression cylinder 27 and the second blanket cylinder 28 serves as the second point of lithographic printing. A transfer cylinder 30 contacts the second impression cylinder 27 downstream of the second blanket cylinder 2 8 in the rotating direction of the second impression cylinder 27.

The plate surface of each of the lithographic plate cylinders 25 and 29 has image areas and non-image areas nearly flush with each other, the image areas being lipophilic and the non-image areas being hydrophilic. Thus, ink (liquid) is transferred by making use of the nature by virtue of which an oil and water repel each other. First, water is given to the plate surface to apply water to the non-image areas. Then, ink is applied, whereupon the ink repels the water and does not adhere to the non-image areas, but adheres only to the image areas. Transfer of the ink in the image areas can result inprinting. Thus, the lithographic printing unit 12, configured as above, prints one surface of the sheet S being transported.

In the reversing unit 13, an attraction cylinder 31 in contact with the transfer cylinder 30 is provided, and a reversing cylinder 32 contacts the attraction cylinder 31 downstream of the transfer cylinder 30 in the rotating direction of the attraction cylinder 31. A transfer cylinder 33 contacts the reversing cylinder 32 downstream of the attraction cylinder 31 in the rotating direction of the reversing cylinder 32. As shown in Figs. 1B and 1C, on an outer peripheral portion of the attraction cylinder 31, gripper devices 201 each composed of a gripper 201a and a gripper pad 201b are arranged with equal spacing, and attraction heads 202 are also arranged with equal spacing, in the circumferential direction of the attraction cylinder 31. On an outer peripheral portion of the reversing cylinder 32, on the other hand, first gripper devices 203 each composed of a gripper 203a and a gripper pad 203b are arranged with equal spacing, and second gripper devices 204 each composed of a gripper 204a and a gripper pad 204b are arranged with equal spacing, in the circumferential direction of the reversing cylinder 32.

Here, the actions of the reversing unit 13 during single-sided printing and double-sided printing will be described. As shown in Fig. 1B, during single-sided printing, on the attraction cylinder 31, a leading end portion of the sheet S is gripped by the gripper 201a and the gripper pad 201b of the gripper device 201, and the sheet S is attracted by the attraction head 202. In this state, the sheet S is transported. When the sheet S is transported to a site in the vicinity of the point of contact between the attraction cylinder 31 and the reversing cylinder 32, a rear end portion of the one surface of the sheet S is once gripped by the gripper 204a and the gripper pad 204b of the second gripper device 204. Then, with the sheet S being passed from the attraction cylinder 31 on to the reversing cylinder 32, the rear end portion of the one surface of the sheet S is passed from between the gripper 204a and the gripper pad 204b of the second gripper device 204 on to between the gripper 203a and the gripper pad 203b of the first gripper device 203. By this action, the sheet S is reversed by the reversing unit 13, and transported such that the one surface of the sheet S is pointed outward on the reversing cylinder 32. Then, the sheet S is supplied to an impression cylinder 34 of the gravure printing unit 14 (to be described later) via the transfer cylinder 33 such that the one surface of the sheet S is pointed outward.

As shown in Fig. 1C, during double-sided printing, on the other hand, the sheet S is transported on the attraction cylinder 31 in the same manner as mentioned above. Then, when the sheet S is transported to a site in the vicinity of the point of contact between the attraction cylinder 31 and the reversing cylinder 32, a leading end portion of the one surface of the sheet S is directly passed from between the gripper 201a and the gripper pad 201b of the gripper device 201 on to between the gripper 203a and the gripper pad 203b of the first gripper device 203. By this action, the sheet S is not reversed by the reversing unit 13, but is transported such that the other surface of the sheet S on the side opposite to the one surface is pointed outward on the reversing cylinder 32. Then, the sheet S is supplied to the gravure printing unit 14 via the transfer cylinder 33. Since a reversing mechanism in the reversing unit 13 has already been known publicly, a detailed description of its structure is omitted herein.

In the gravure printing unit 14, an impression cylinder 34 in contact with the transfer cylinder 33 is provided. A gravure plate cylinder (intaglio plate cylinder) 35 contacts the impression cylinder 34 downstream of the transfer cylinder 33 in the rotating direction of the impression cylinder 34. That is, the point of contact between the impression cylinder 34 and the gravure plate cylinder 35 serves as the point of gravure printing. The plate surface of the gravure plate cylinder 35 has non-image areas 35a forming the outermost plane of the plate surface, and recessed image areas (recessed portion) 35b, which are lower in height than the non-image areas 35a (see Fig. 2).

An ink roller 36 contacts the gravure plate cylinder 35 downstream of the impression cylinder 34 in the rotating direction of the gravure plate cylinder 35. A lower side of the ink roller 36 is immersed in an ink reservoir 37 where ink (liquid) is stored inside. The ink roller 36 and the ink reservoir 37 constitute a liquid supply means. A doctor (surplus liquid removal means) 38 contacts the gravure plate cylinder 35 downstream of the ink roller 36 in the rotating direction of the gravure plate cylinder 35 and upstream of the impression cylinder 34 in the rotating direction of the gravure plate cylinder 35. The doctor 38 removes surplus ink deposited on the non-image areas 35a of the gravure plate cylinder 35. Moreover, an IC chip supply device (medium supply means) 50 contacts the gravure plate cylinder 35 downstream of the doctor 38 in the rotating direction of the gravure plate cylinder 35 , and upstream of the impression cylinder 34 in the rotating direction of the gravure plate cylinder 35. The IC chip supply device 50 supplies an IC chip (information recording medium) where printing information, product information, etc. on the sheet S are recorded. Thus, the gravure printing unit 14, which has the above-describedfeatures,appliesprintingto the onesurface or the other surface of the sheet S being transported.

The printing information or product information recorded on the IC chip refers, for example, to an encryption which identifies whether a sheet S after completion of printing, if it is a security such as a banknote or a gift certificate, is fake or real; ortoaproducer, anagricultural chemical, history of production and distribution processes, and so on if the sheet S is a price tag on a food product.

In the delivery unit 15, a pair of sprockets 39a and 39b are provided. The sprocket 39a contacts the impression cylinder 34, and a delivery chain 40 is looped between the sprockets 39a and 39b. A plurality of gripper bars (not shown) for receiving the sheet S from the impression cylinder 34 are mounted on the delivery chain 40 at predetermined intervals along the travel direction of the delivery chain 40. Upon travel of the delivery chain 40, the sheet S is delivered downwardly of the delivery chain 40.

Next, the information recording medium supply apparatus will be described using Fig. 2.

As shown in Fig. 2, a transport path 51 extending from an IC chip storage (not shown), where IC chips are stored, is provided in the IC chip supply device 50. The transport path 51 assumes a rectangular tubular shape, and is composed of an upper plate (second guide) 52, a lower plate (first guide) 53, and side plates (not shown). The transport path 51 is inclined downwardly toward its leading end, and a clearance of the length of nearly one IC chip is formed between the leading end of the upper plate 52 and the gravure plate cylinder 35, while a tiny clearance is formed between the leading end of the lower plate 53 and the gravure plate cylinder 35. A support member 57, which is pivotably supported by a pin 56, is provided on the proximal end side of the lower surface of the lower plate 53. On the other hand, the cam surface of a cam 55, which is connected to a cam drive motor 54, is in contact with the distal end side of the lower surface of the lower plate 53.

That is, when the cam drive motor 54 is driven to rotate the cam 55, the transport path 51 has its leading end swung in a vertical direction about the pin 56. As a result, the IC chip is oscillated, dispatched from the IC chip storage into the transport path 51, and then moved toward the leading end of the transport path 51.

As described above, the IC chip supply device (medium supply means) 50 is composed of the transport path 51, the upper plate 52, the lower plate 53, the cam drive motor 54, the cam 55, the pin 56, and the support member 57. Of these constituents, the cam drive motor 54, the cam 55, the pin 56, and the support member 57 constitute oscillation means.

Because of the above-described features, therefore, when the IC chip is to be embedded in the same surface as the one surface of the sheet S where lithographic printing has been done (in the case of single-sided printing), the sheet S fed to the sheet feeding plate 21 is passed on to the first impression cylinder 23 via the swing arm shaft pregripper. Then, the sheet S is supplied between the first impression cylinder 23 and the first blanket cylinder 24. At this time, the ink is transferred from the first lithographic plate cylinder 25 to the sheet S via the first blanket cylinder 24, whereby first lithographic printing is done on the one surface of the sheet S.

Further, the sheet S subjected to the first lithographic printing is passed on to the second impression cylinder 27 via the transfer cylinder 26, and then supplied between the second impression cylinder 27 and the second blanket cylinder 28. At this time, the ink is transferred from the second lithographic plate cylinder 29 to the sheet S via the second blanket cylinder 28, whereby second lithographic printing is done on the one surface of the sheet S.

The sheet S subjected to the second lithographic printing is passed on to the attraction cylinder 31 via the transfer cylinder 30, and then supplied between the attraction cylinder 31 and the reversing cylinder 32. Here, the sheet S is reversed by the reversing unit 13, and the reversed sheet S is transported, with the one surface thereof being pointed outward on the reversing cylinder 32. Then, the sheet S is passed on to the impression cylinder 34 via the transfer cylinder 33, and supplied between the impression cylinder 34 and the gravure plate cylinder 35.

The ink stored in the ink reservoir 37 is supplied to the gravure plate cylinder 35 via the ink roller 36. Surplus ink adhering to the non-image areas 35a of the gravure plate cylinder 35 is removed by the doctor 38, so that only the ink within the image areas 35b of the gravure plate cylinder 35 remains.

When, at the same time, the cam drive motor 54 is driven to rotate the cam 55, the transport path 51 is swung about the pin 56 in the vertical direction by a high portion and a low portion formed in the cam surface. Owing to oscillations due to the swing motion, the IC chip is sent out of the IC chip storage into the transport path 51, and then moved toward the leading end of the transport path 51. The IC chip transported to the leading end of the transport path 51 contacts the non-image area 35a of the gravure plate cylinder 35, and slides on the circumferential surface of the non-image area 35a. Then, this IC chip contacts the image area 35b being rotated, and adheres (sticks) to the surface of the ink because of the viscosity of the ink stored within the image area 35b. Then, the IC chip, while adhering to the surface of the ink, is discharged through the clearance at the leading end of the upper plate 52, and transported to a site between the gravure plate cylinder 35 and the impression cylinder 34.

Then, the IC chip adhering to the surface of the ink moves (transfers) to the sheet S, together with the ink stored within the image area 35b, at the site between the impression cylinder 34 and the gravure plate cylinder 35. That is, the ink is transferred from the image area 35b of the gravure plate cylinder 35 to the one surface of the sheet S held on the impression cylinder 34, whereby gravure printing on, and embedding of the IC chip into, the one surface of the sheet S are carried out. On this occasion, the ink stored within the image area 35b of the gravure plate cylinder 35 is transferred to the sheet S in such a manner as to wrap the IC chip in. The sheet S, where gravure printing and embedding of the IC chip have been performed, is passed on to the delivery chain 40, and then delivered.

When the IC chip is to be embedded in the other surface of the sheet S on the side opposite to the one surface thereof subjected to lithographic printing (in the case of double-sided printing), on the other hand, the sheet S supplied between the attraction cylinder 31 and the reversing cylinder 32 is not reversed in the reversing unit 13. That is, the sheet S is not reversed by the reversing unit 13, but is transported, with the other surface thereof being pointed outward on the reversing cylinder 32, and is then passed on to the impression cylinder 34 via the transfer cylinder 33.

Then, the IC chip adhering to the surface of the ink moves (transfers) to the sheet S, together with the ink stored within the image area 35b, at the site between the impression cylinder 34 and the gravure plate cylinder 35. That is, the ink is transferred from the image area 35b of the gravure plate cylinder 35 to the other surface of the sheet S held on the impression cylinder 34, whereby gravure printing on, and embedding of the IC chip into, the other surface of the sheet S are carried out. On this occasion, the ink stored within the image area 35b of the gravure plate cylinder 35 is transferred to the sheet S in such a manner as to wrap the IC chip in. The sheet S, where gravure printing and embedding of the IC chip have been performed, is passed on to the delivery chain 40, and then delivered.

Thus, according to the information recording medium supply apparatus concerned with the present invention, the IC chip can be embedded in the sheet S efficiently. Moreover, embedding of the IC chip can be performed simultaneously with ink transfer to the sheet S. Thus, there is no need to add anew a step for embedding the IC chip, and a printing product provided with the IC chip can be completed in one pass. Furthermore, the IC chip is disposed within the ink, thus making it difficult to determine whether the IC chip is present or absent, and making it possible to produce a printing product having a high degree of forgery preventing function.

### Embodiment 2

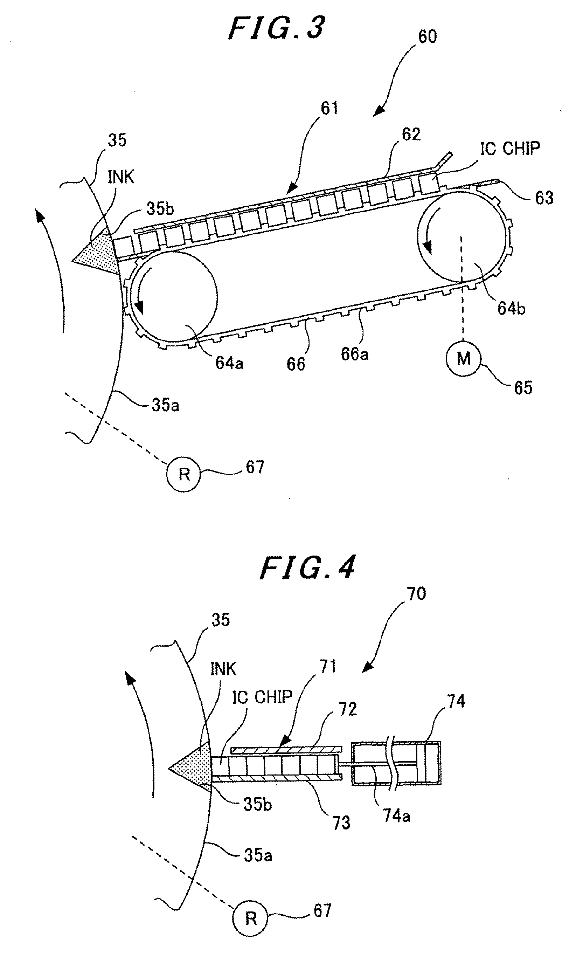

Fig. 3 is a schematic view of the information recording medium supply apparatus according to a second embodiment of the present invention.

As shown in Fig. 3, a transport path 61 extending from an IC chip storage (not shown), where IC chips are stored, is provided in an IC chip supply device (medium supply means) 60. The transport path 61 assumes a rectangular tubular shape, and is composed of an upper plate (second guide) 62, a lower plate (first guide) 63, and side plates (not shown). The transport path 61 is inclined downwardly toward its leading end, and a clearance of the length of nearly one IC chip is formed between the leading end of the upper plate 62 and the gravure plate cylinder 35, while a tiny clearance is formed between the leading end of the lower plate 63 and the gravure plate cylinder 35.

A pair of drive rollers 64a and 64b are provided below the lower plate 63, and a roller drive motor 65 is connected to the drive roller 64b. A grooved belt (transport belt) 66 is looped between the drive rollers 64a and 64b, and a plurality of grooves (engagement portions) 66a are formed on the outside of the grooved belt 66. The upper part of the grooved belt 66 located between the drive rollers 64a and 64b is disposed in a groove (not shown) of the lower plate 63 which is formed in the extending direction of the transport path 61. A rotary encoder (detection means) 67 is connected to the gravure plate cylinder 35.

As described above, the IC chip supply device (medium supply means) 60 is composed of the transport path 61, the upper plate 62, the lower plate 63, the drive rollers 64a, 64b, the roller drive motor 65, the grooved belt 66, the grooves 66a, and the rotary encoder 67. Of these constituents, the drive rollers 64a, 64b, the roller drive motor 65, the grooved belt 66, and the grooves 66a constitute push-out means.

Because of the above-described features, therefore, when the roller drive motor 65 is driven to drive the drive rollers 64a, 64b, the grooved belt 66 is rotated counterclockwise. In accordance with this motion, the IC chips, which have been moved from the IC chip storage, are fitted, one by one, into the grooves 66a of the grooved belt 66, and then moved toward the leading end of the transport path 61. The rotation angle of the image area 35b of the gravure plate cylinder 35 is detected by the rotary encoder 67, and the grooved belt 66 is intermittently driven by the roller drive motor 65 in timed relationship with the image area 35b being rotated. By so doing, the IC chip is pushed out into the ink stored within the image area 35b. Then, the IC chip within the ink moves (transfers) to the sheet S, together with the ink stored within the image area 35b, at the site between the impression cylinder 34 and the gravure plate cylinder 35.

Thus, according to the information recording medium supply apparatus concerned with the present invention, the IC chip can be embedded in the sheet S efficiently. Moreover, embedding of the IC chip can be performed simultaneously with ink transfer to the sheet S. Thus, there is no need to add anew a step for embedding the IC chip, and a printing product provided with the IC chip can be completed in one pass. Furthermore, the IC chip is disposed within the ink, thus making it difficult to determine whether the IC chip is present or absent, and making it possible to produce a printing product having a high degree of forgery preventing function.

### Embodiment 3

Fig. 4 is a schematic view of the information recording medium supply apparatus according to a third embodiment of the present invention.

As shown in Fig. 4, a transport path 71 extending in a nearly horizontal direction to face the gravure plate cylinder 35, is provided in an IC chip supply device (medium supplymeans) 70. The transport path 71 assumes a rectangular tubular shape, and is composed of an upper plate (second guide) 72, a lower plate (first guide) 73, and side plates (not shown). A clearance of the length of nearly one IC chip is formed between the leading end of the upper plate 72 and the gravure plate cylinder 35, while a tiny clearance is formed between the leading end of the lower plate 73 and the gravure plate cylinder 35. An air cylinder (hydraulic cylinder) 74 is provided on the proximal end side of the transport path 71, and a rod portion 74a of the air cylinder 74 is in contact with the IC chip located on the proximal end side of the transport path 71.

As described above, the IC chip supply device (medium supply means) 70 is composed of the transport path 71, the upper plate 72, the lower plate 73, the air cylinder 74, and the rod portion 74a. Of these constituents, the air cylinder 74 and the rodportion 74a constitute push-out means.

Because of the above-described features, therefore, the rotation angle of the image area 35b of the gravure plate cylinder 35 is detected by a rotary encoder 67, and the air cylinder 74 is actuated in timed relationship with the image area 35b being rotated, thereby extending the rod portion 74a. By so doing, the IC chip is pushed out into the ink stored within the image area 35b. Then, the IC chip within the ink moves (transfers) to the sheet S, together with the ink stored within the image area 35b, at the site between the impression cylinder 34 and the gravure plate cylinder 35. It is permissible to operate the air cylinder 74 such that the rod portion 74a always pushes the IC chip at a constant pressure.

Thus, according to the information recording medium supply apparatus concerned with the present invention, the IC chip can be embedded in the sheet S efficiently. Moreover, embedding of the IC chip can be performed simultaneously with ink transfer to the sheet S. Thus, there is no need to add anew a step for embedding the IC chip, and a printing product provided with the IC chip can be completed in one pass. Furthermore, the IC chip is disposed within the ink, thus making it difficult to determine whether the IC chip is present or absent, and making it possible to produce a printing product having a high degree of forgery preventing function.

### Embodiment 4

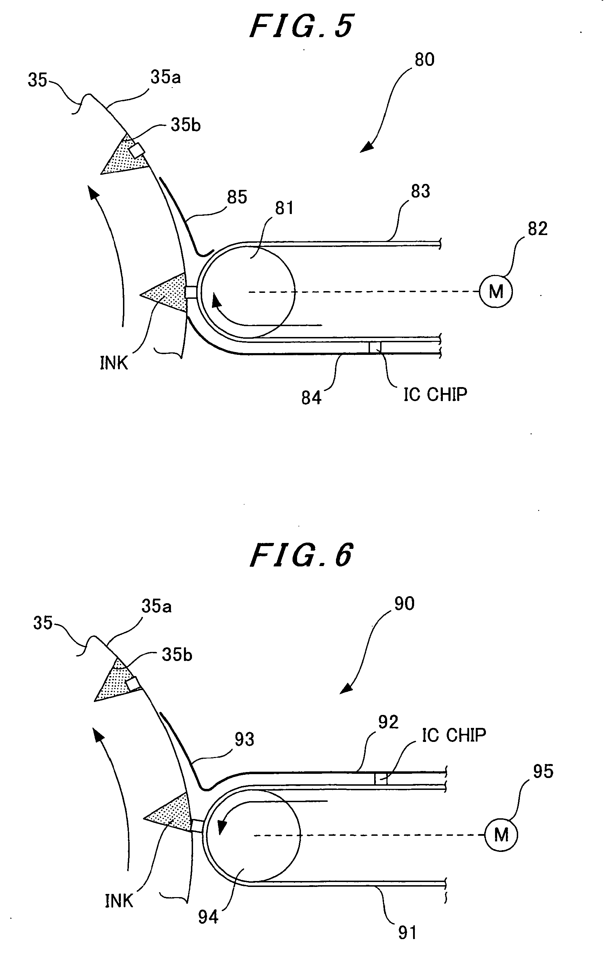

Fig. 5 is a schematic view of the information recording medium supply apparatus according to a fourth embodiment of the present invention.

As shown in Fig. 5, a pair of drive rollers 81 (only one of these rollers is illustrated) are provided in an IC chip supply device (medium supply means) 80. The pair of drive rollers 81 are disposed between an IC chip storage (not shown), where IC chips are stored, and the gravure plate cylinder 35. A roller drive motor 82 is connected to one of the drive rollers 81, and an adhesive belt 83 is looped between the drive rollers 81. Apredetermined adhesive force has been imparted to the surface of the adhesive belt 83.

A transport guide 84 extending between the IC chip storage and the gravure plate cylinder 35 is provided below the lower part of the adhesive belt 83 located between the drive rollers 81. The transport guide 84 is disposed to be spaced from the adhesive belt 83 by a clearance of the length of nearly one IC chip. A chip guide (push-in means) 85 formed of an elastic body is provided above a position where the gravure plate cylinder 35 and the adhesive belt 83 oppose each other. The chip guide 85 extends from the adhesive belt 83 up to the gravure plate cylinder 35, and is formed to be spaced from the gravure plate cylinder 35 by a clearance decreasing as the chip guide 85 approaches the gravure plate cylinder 35.

As described above, the IC chip supply device (medium supply means) 80 is composed of the drive rollers 81, the roller drive motor 82, the adhesive belt 83, the transport guide 84, and the chip guide 85. Of these constituents, the drive rollers 81 and the roller drive motor 82 constitute adhesive belt moving means.

Because of the above-described features, when the roller drive motor 82 is driven to drive the drive rollers 81, the adhesive belt 83 rotates (moves) clockwise. In accordance with this motion, the IC chip, which has moved from the IC chip storage, moves toward the gravure plate cylinder 35 along the transport guide 84 while being stuck under the adhesive force of the adhesive belt 83. Upon contact with the image area 35b being rotated, the IC chip adheres to the surface of the ink because of the viscosity of the ink stored in the image area 35b (the ink has higher viscosity than the adhesive force of the adhesive belt 83). Then, the IC chip adhering to the surface of the ink is transported to be brought into contact with the chip guide 85, and gradually pushed into the ink. Then, the IC chip within the ink moves (transfers) to the sheet S, together with the ink stored within the image area 35b, at the site between the impression cylinder 34 and the gravure plate cylinder 35.

Thus, according to the information recording medium supply apparatus concerned with the present invention, the IC chip can be embedded in the sheet S efficiently. Moreover, embedding of the IC chip can be performed simultaneously with ink transfer to the sheet S. Thus, there is no need to add anew a step for embedding the IC chip, and a printing product provided with the IC chip can be completed in one pass. Furthermore, the IC chip is disposed within the ink, thus making it difficult to determine whether the IC chip is present or absent, and making it possible to produce a printing product having a high degree of forgery preventing function.

### Embodiment 5

Fig. 6 is a schematic view of the information recording medium supply apparatus according to a fifth embodiment of the present invention.

As shown in Fig. 6, a pair of drive rollers 94 (only one of them is illustrated) are provided in an IC chip supply device (medium supply means) 90. The pair of drive rollers 94 are disposed between an IC chip storage (not shown), where IC chips are stored, and the gravure plate cylinder 35. A roller drive motor 95 is connected to one of the drive rollers 94, and a charged belt 91 is looped between the drive rollers 94. The surface of the charged belt 91 has been electrostatically charged.

A transport guide 92 extending between the IC chip storage and the gravure plate cylinder 35 is provided above the upper part of the charged belt 91 located between the drive rollers 94. The transport guide 92 is disposed to be separated from the charged belt 91 by a clearance of the length of nearly one IC chip. A chip guide (push-in means) 93 formed of an elastic body is provided at the leading end of the transport guide 92. The chip guide 93 extends from the charged belt 91 up to the gravure plate cylinder 35, and is formed to be spaced from the gravure plate cylinder 35 by a clearance decreasing as the chip guide 93 approaches the gravure plate cylinder 35.

As described above, the IC chip supply device (medium supply means) 90 is composed of the charged belt 91, the transport guide 92, the chip guide 93, the drive rollers 94, and the roller drive motor 95. Of these constituents, the drive rollers 94 and the roller drive motor 95 constitute charged belt moving means.

Because of the above-described features, when the roller drive motor 95 is driven to drive the drive rollers 94, the charged belt 91 rotates (moves) counterclockwise. In accordance with this motion, the IC chip, which has moved from the IC chip storage (not shown) , moves toward the gravure plate cylinder 35 along the transport guide 92 while being attracted by the static electricity of the charged belt 91. Upon contact with the image area 35b being rotated, the IC chip adheres to the surface of the ink because of the viscosity of the ink stored within the image area 35b (the ink has higher viscosity than the static electricity of the charged belt 91). Then, the IC chip adhering to the surface of the ink is transported to be brought into contact with the chip guide 93, and gradually pushed into the ink. Then, the IC chip within the ink moves (transfers) to the sheet S, together with the ink stored within the image area 35b, at the site between the impression cylinder 34 and the gravure plate cylinder 35.

Thus, according to the information recording medium supply apparatus concerned with the present invention, the IC chip can be embedded in the sheet S efficiently. Moreover, embedding of the IC chip can be performed simultaneously with ink transfer to the sheet S. Thus, there is no need to add anew a step for embedding the IC chip, and a printing product provided with the IC chip can be completed in one pass. Furthermore, the IC chip is disposed within the ink, thus making it difficult to determine whether the IC chip is present or absent, and making it possible to produce a printing product having a high degree of forgery preventing function.

With the IC chip supply devices 50, 60, 70, 80 and 90 of Embodiments 1 to 5, the IC chip is embedded simultaneously with gravure printing (intaglio printing) after lithographic printing. However, gravure printing (intaglio printing) may be combined not with lithographic printing, but with other printing method, for example, intaglio printing, which is the same printing method, stencil printing, or relief printing.

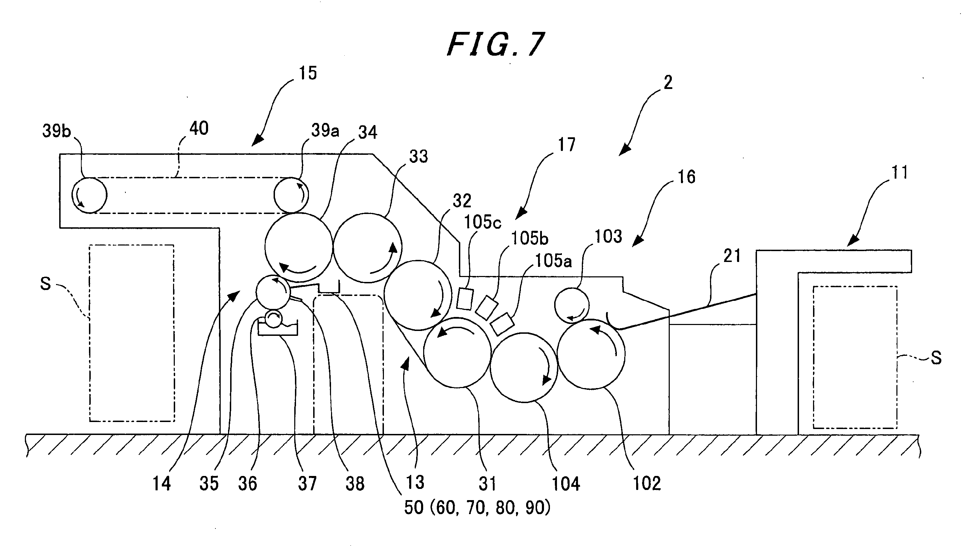

A combination with relief printing, as shown in Fig. 7, will be explained as an example of combination with other printing method.

As shown in Fig. 7, a sheet-fed rotary press 2 is equipped with a feeder 11, a numbering unit (relief printing unit) 16, a drying unit 17, a reversing unit 13, a gravure printing unit 14, and a delivery unit 15. The sheet S passes through these devices sequentially, and thereby undergoes printing.

An impression cylinder 102, which receives the sheet S fed from a sheet feeding plate 21 via a swing arm shaft pregripper (not shown), is provided in the numbering unit 16. A relief plate cylinder 103 contacts the impression cylinder 102 downstream of the sheet feeding plate 21 in the rotating direction of the impression cylinder 102. That is, the point of contact between the impression cylinder 102 and the relief plate cylinder 103 serves as the point of relief printing. A transfer cylinder 104 contacts the impression cylinder 102 downstream of the relief plate cylinder 103 in the rotating direction of the impression cylinder 102. The plate surface of the relief plate cylinder 103 has image areas where ink deposits, and non-image areas which are lower in height than the image areas and on which no ink deposits. This plate surface is intended for printing of serial numbers (numerals) on the sheets transported sequentially, and printing types for these serial numbers are formed in the image areas.

The drying unit 17 is provided with UV lamps 105a, 105b and 105c which oppose the upper circumferential surface of an attraction cylinder 31 and which are arranged in parallel. That is, the UV lamps 105a, 105b and 105c throw ultraviolet rays from above the attraction cylinder 31 toward the upper circumferential surface of the attraction cylinder 31 to dry ink on one surface of the sheet S attracted to the attraction cylinder 31.

Because of the above-described features, therefore, when the IC chip is to be embedded in the one surface of the sheet S (in the case of single-sided printing) , the sheet S fed to the sheet feeding plate 21 is passed on to the impression cylinder 102 via the swing arm shaft pregripper. Then, the sheet S is supplied between the impression cylinder 102 and the relief plate cylinder 103. Since the ink is transferred to the sheet S thereby, relief printing is done on the one surface of the sheet S.

The sheet S subjected to the relief printing is passed on to the attraction cylinder 31 via the transfer cylinder 104, and has the one surface thereof dried by irradiation from the UV lamps 105a, 105b and 105c. Then, the dried sheet S is supplied between the attraction cylinder 31 and a reversing cylinder 32. Here, the sheet S is reversed by the reversing unit 13, and the reversed sheet S is transported, with the one surface thereof being pointed outward on the reversing cylinder 32. Then, the sheet S is passed on to an impression cylinder 34 via a transfer cylinder 33. The sheet S passed on to the impression cylinder 34 is supplied between the impression cylinder 34 and a gravure plate cylinder 35.

Ink stored in an ink reservoir 37 is supplied to the gravure plate cylinder 35 via an ink roller 36. Surplus ink adhering to non-image areas 35a of the gravure plate cylinder 35 is removed by a doctor 38, so that only the ink within image areas 35b of the gravure plate cylinder 35 remains. Then, an IC chip is supplied to the ink within the image area 35b by the action of the aforementioned IC chip supply device 50, 60, 70, 80 or 90.

Then, the IC chip supplied to the ink moves (transfers) to the sheet S, together with the ink stored within the image area 35b, at the site between the impression cylinder 34 and the gravure plate cylinder 35. That is, the ink is transferred from the image area 35b of the gravure plate cylinder 35 to the one surface of the sheet S held on the impression cylinder 34, whereby gravure printing on, and embedding of the IC chip into, the one surface of the sheet S are carried out. On this occasion, the ink stored in the image area 35b of the gravure plate cylinder 35 is transferred to the sheet S in such a manner as to wrap the IC chip in. The sheet S, where gravure printing and embedding of the IC chip have been performed, is passed on to a delivery chain 40, and then delivered.

When the IC chip is to be embedded in the other surface of the sheet S (in the case of double-sided printing), on the other hand, the sheet S supplied between the attraction cylinder 31 and the reversing cylinder 32 is not reversed in the reversing unit 13. That is, the sheet S is not reversed by the reversing unit 13, but the other surface thereof on the side opposite to the one surface is pointed outward on the reversing cylinder 32, and is then passed on to the impression cylinder 34 via the transfer cylinder 33.

Then, the IC chip supplied to the ink moves (transfers) to the sheet S, together with the ink stored within the image area 35b, at the site between the impression cylinder 34 and the gravure plate cylinder 35. That is, the ink is transferred from the image area 35b of the gravure plate cylinder 35 to the other surface of the sheet S held on the impression cylinder 34, whereby gravure printing on, and embedding of the IC chip into, the other surface of the sheet S are carried out. On this occasion, the ink stored within the image area 35b of the gravure plate cylinder 35 is transferred to the sheet S in such a manner as to wrap the IC chip in. The sheet S, where gravure printing and embedding of the IC chip have been performed, is passed on to the delivery chain 40, and then delivered.

Accordingly, even the combination with relief printing enables the IC chip to be embedded in the sheet S efficiently.

With the sheet-fed rotary press 1 or 2 equipped with the IC chip supply device 50, 60, 70, 80 or 90 according to the present invention, the lithographic printing unit 12 or the numbering unit 16 is disposed upstream of the gravure printing unit 14 in the sheet transport direction. Thus, the embedded IC chip is not destroyed. That is, if the sheet S subjected to gravure printing undergoes lithographic printing or relief printing, there is a possibility for destruction of the IC chip embedded in the sheet S. According to the present invention, by contrast, gravure printing, which involves embedding of the IC chip, is performed after lithographic printing or relief printing. Hence, the destruction of the embedded IC chip can be prevented.

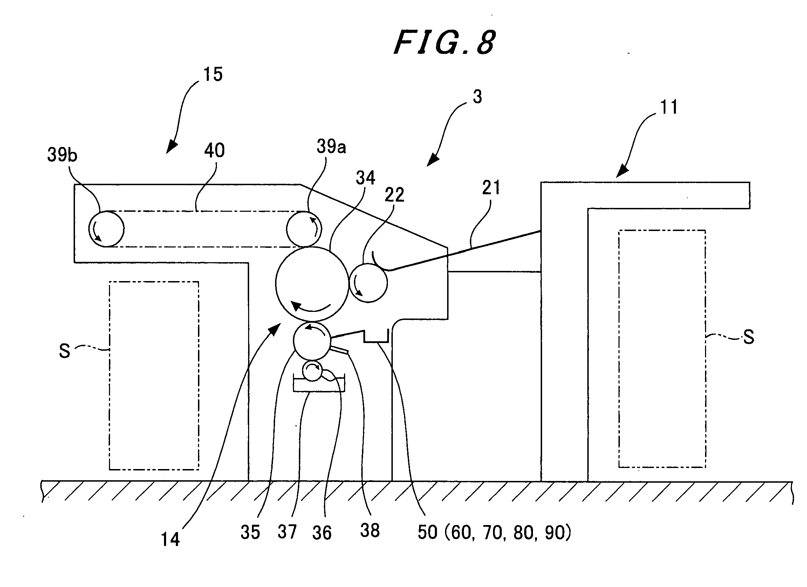

Furthermore, even when a sheet-fed rotary press 3 is equipped with a feeder 11, a gravure printing unit 14, and a delivery unit 15 to do only gravure printing on the sheet S, as shown in Fig. 8, the IC chip supply devices 50, 60, 70, 80, 90 of Embodiments 1 to 5 can be applied. Even in this configuration, the IC chip can be embedded in the sheet S efficiently.

The information recording medium supply apparatus of the present invention is applicable to a coating machine which forms a coating of a synthetic resin or the like on a surface of paper.

While the present invention has been described by the above embodiments, it is to be understood that the invention is not limited to these embodiments, but may be varied in many other ways. In these embodiments, the IC chip is used as the information recording medium, but an IC tag can be used. Also, the ink is used as the liquid, but a varnish may be used to coat an IC chip or an IC tag. Besides, the sheet, which is a sheet of paper, is used herein, but a polyvinyl chloride sheet, a plastic sheet, or a base board or substrate may be used. Such variations are not to be regarded as a departure from the spirit and scope of the invention, and all such modifications as would be obvious to one skilled in the art are intended to be included within the scope of the following claims.

## Claims

1. An information recording medium supply apparatus, comprising:
a cylinder (35) supported rotatably, and having a recessed portion (35b) formed in a circumferential surface thereof;
liquid supply means (36, 37) for supplying a liquid to the circumferential surface of the cylinder (35);
surplus liquid removal means (38) for removing a surplus of the liquid adhering to a portion (35a) other than the recessed portion (35b);
an impression cylinder (34) supported rotatably and adapted to transfer the liquid in the recessed portion (35b) to a sheet (S) being transported in cooperation with the cylinder (35); and
medium supply means (50, 60, 70, 80, 90) for supplying an information recording medium, where information is recorded, to the liquid in the recessed portion (35b) on a side downstream of a point of removal of the liquid by the surplus liquid removal means (38) in a rotating direction of the cylinder (35), and on a side upstream of a point of contact with the impression cylinder (34) in the rotating direction of the cylinder (35).

2. The information recording medium supply apparatus according to claim 1, **characterized in that** the medium supply means (50) comprises:
a transport path (51) extending toward the cylinder (35) ; and
oscillation means (54, 55, 56, 57) which oscillates the transport path (51) to supply the information recording medium from the transport path (51) to the liquid in the recessed portion (35b).

3. The information recording medium supply apparatus according to claim 2, **characterized in that** the oscillation means (54, 55, 57) comprises:
a support member (57) for supporting the transport path (51) to be pivotable;
a cam (55) in contact with a lower surface of the transport path (51); and
a cam drive motor (54) for rotationally driving the cam (55).

4. The information recording medium supply apparatus according to claim 1, **characterized in that** the medium supply means (60) comprises:
a transport belt (66) which travels to supply the information recording medium to the liquid in the recessed portion (35b).

5. The information recording medium supply apparatus according to claim 1, **characterized in that** the medium supply means (70) comprises:
a hydraulic cylinder (74) which actuates a piston rod (74a) to supply the information recording medium to the liquid in the recessed portion (35b).

6. The information recording medium supply apparatus according to claim 1, **characterized in that** the medium supply means (80) comprises:
an adhesive belt (83) for holding the information recording medium by an adhesive force; and
adhesive belt moving means (81, 82) which moves the adhesive belt (83) to supply the information recording medium to the liquid in the recessed portion (35b).

7. The information recording medium supply apparatus according to claim 1, **characterized in that** the medium supply means (90) comprises:
a charged belt (91) for holding the information recording medium by static electricity; and
charged belt moving means (94, 95) which moves the charged belt (91) to supply the information recording medium to the liquid in the recessed portion (35b).

8. The information recording medium supply apparatus according to claim 1, **characterized in that** the information recording medium
sticks to the liquid in the recessed portion (35b) because of viscosity of the liquid when contacting the liquid, and
is rotated and transported, together with the liquid, in accordance with rotation of the cylinder (35).

9. The information recording medium supply apparatus according to claim 8, **characterized in that**
the information recording medium slides on the circumferential surface (35a) of the cylinder (35) other than the recessed portion (35b).

10. The information recording medium supply apparatus according to claim 1, further comprising:
push-out means (64a, 64b, 65, 66, 66a, 74, 74a) for pushing the information recording medium out toward the liquid in the recessedportion (35b) when the recessedportion (35b) and the medium supply means (64a, 64b, 65, 66, 66a, 74, 74a) oppose each other.

11. The information recording medium supply apparatus according to claim 1, further comprising:
push-in means (85, 93) for pushing the information recording medium, which has been supplied to the recessed portion (35b) , into the liquid in the recessed portion (35b) gradually in accordance with rotation of the cylinder (35).

12. The information recording medium supply apparatus according to claim 1, **characterized in that**
an intaglio printing unit (14) is composed of the cylinder (35) , the liquid supply means (36, 37) , the surplus liquid removal means (38) , and the impression cylinder (34) .

13. The information recording medium supply apparatus according to claim 1, **characterized in that**
the information recording medium is transferred to the sheet (S) , which is held on the impression cylinder (34), together with the liquid in the recessed portion (35b).

14. The information recording medium supply apparatus according to claim 13, **characterized in that**
the information recording medium is disposed within the liquid transferred to the sheet (S).

15. The information recording medium supply apparatus according to claim 1, **characterized in that**
the information recording medium is an IC chip.

16. The information recording medium supply apparatus according to claim 1, **characterized in that**
the medium supply means (50, 60, 70) includes a transport path (51, 61, 71) comprising
a first guide (53, 63, 73) extending toward the cylinder (35) and disposed upstream in the rotating direction of the cylinder (35), and
a second guide (52, 62, 72) extending toward the cylinder (35) and disposed downstream in the rotating direction of the cylinder (35),
a leading end of the first guide (53, 63, 73) has a small clearance with respect to the cylinder (35), and
a leading end of the second guide (52, 62, 72) has a clearance, which is of a length substantially equal to a length of the information recording medium, with respect to the cylinder (35).

17. The information recording medium supply apparatus according to claim 1, **characterized in that**
the medium supply means (50, 60) includes a transport path (51, 61) extending toward the cylinder (35), and
the transport path (51, 61) is inclined downwardly from an upstream side in a transport direction of the information recording medium toward a downstream side in the transport direction of the information recording medium.

18. The information recording medium supply apparatus according to claim 4, **characterized in that**
the transport belt (66) has a plurality of engagement portions (66a) for transporting the information recording medium toward the cylinder (35), and
the information recording medium engages each of the engagement portions (66a).

19. The information recording medium supply apparatus according to claim 4, further comprising:
detection means (67) for detecting a rotation phase of the recessed portion (35b); and
a drive motor (65) for driving the transport belt (66),
wherein the drive motor (65) is driven in accordance with the rotationphase of the recessedportion (35b) detected by the detection means (67).

20. The information recording medium supply apparatus according to claim 5, further comprising:
detection means (67) for detecting a rotation phase of the recessed portion (35b),
wherein the hydraulic cylinder (74) is driven in accordance with the rotation phase of the recessed portion (35b) detected by the detection means (67).

21. The information recording medium supply apparatus according to claim 3, **characterized in that**
the support member (57) supports a proximal end side of the transport path (51), and
the cam (55) contacts a distal end side of the transport path (51).

22. The information recording medium supply apparatus according to claim 11, **characterized in that**
the push-in means (85, 93) is spaced from the cylinder (35) by a clearance decreasing as the push-in means (85, 93) extends from an upstream side in the rotating direction of the cylinder (35) toward a downstream side in the rotating direction of the cylinder (35).

23. The information recording medium supply apparatus according to claim 12, further comprising:
a delivery unit (15) downstream of the intaglio printing unit (14) in a transport direction of the sheet (S),
and not including a printing unit (12, 16) between the intaglio printing unit (14) and the delivery unit (15).

24. The information recording medium supply apparatus according to claim 12, further comprising:
a printing unit (12, 16) upstream of the intaglio printing unit (14) in a transport direction of the sheet (S).

25. The information recording medium supply apparatus according to claim 24, further comprising:
a reversing device (13), provided between the printing unit (12, 16) and the intaglio printing unit (14), for switching between double-sided printing and single-sided printing on the sheet (S).

26. The information recording medium supply apparatus according to claim 24, **characterized in that**
the printing unit (12) is a lithographic printing unit (12).

27. The information recording medium supply apparatus according to claim 24, **characterized in that**
the printing unit (16) is a relief printing unit (16).
